# EUROPEAN PATENT APPLICATION

(11) **EP 3 757 453 A1**
(43) Date of publication of application: **30.12.2020**
(21) Application number: 19753723.6
(22) Date of filing: 18.02.2019
(51) Int. Cl.: F21V 5/00, F21S 4/20, F21V 5/02, G02B 5/00, H01L 33/00, H01L 33/58, H01L 33/60, F21Y 115/10, G09F 13/20

(54) **LUMINOUS FLUX CONTROL MEMBER, LIGHT EMISSION DEVICE, AND ILLUMINATION DEVICE**

(30) Priority: 19.02.2018 JP 2018027155
(71) Applicant: Enplas Corporation, Kawaguchi-shi, Saitama 332-0034 (JP)
(72) Inventor: SEKI, Akinobu, Saitama 332-0034 (JP); SHINOHARA, Hiroyuki, Saitama 332-0034 (JP)
(74) Representative: Epping - Hermann - Fischer
(86) International application number: PCT/JP2019/005837
(87) International publication number: WO 2019/160137

(57) **Abstract**

This luminous flux control member has: an incident surface; two reflection surfaces and two emission surfaces. The incident surface has: a first incident surface that intersects with the light axis of the light emission element; and two second incident surfaces that sandwich the first incident surface and are disposed in a Y-axis direction that the two emission surfaces face. A plurality of first projecting ridges having ridgelines that are substantially parallel to the Y-axis direction are disposed on the first incident surface. A plurality of second projecting ridges having ridgelines that are substantially parallel to the light axis are disposed on the two emission surfaces, or a plurality of third projecting ridges having ridgelines that are substantially intersecting with the first projecting ridges are disposed on at least a part of the two reflection surfaces.

## Description

### Technical Field

The present invention relates to a light flux controlling member, a light-emitting device and an illumination apparatus.

### Background Art

A light-emitting device including a light-emitting element such as an LED is used as a light source of an illumination apparatus and a sign board. Among them, as a light source of a channel letter sign board having a special shape, a light-emitting device is used in which light emitted from a light-emitting element is reflected in two opposite directions along the horizontal direction so as to have anisotropic light distribution characteristics (or have an elliptic light distribution).

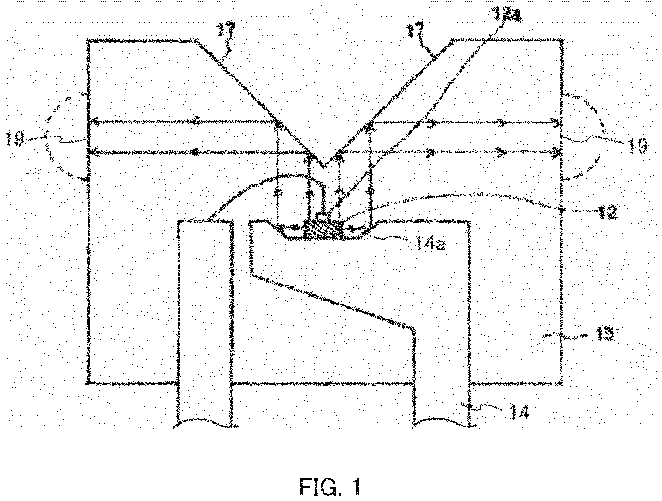

As a light-emitting device having an anisotropic light distribution characteristics, PTL 1 discloses a light-emitting device including light-emitting element 12, base (chip mounting lead) 14 having reflection cup 14a configured to reflect light emitted from light-emitting element 12 upward, and light flux controlling member 13 (in PTL 1, an optically transparent resin) configured to cover light-emitting element 12 and reflection cup 14a as illustrated in FIG. 1, for example. Light flux controlling member 13 includes two reflecting surfaces 17 configured to reflect light emitted from light-emitting element 12 and light reflected by reflection cup 14a, and two emission surfaces 19 (in PTL 1, a side surface) configured to emit, to outside, light reflected by reflecting surface 17.

In such a light-emitting device, light emitted from the top surface of light-emitting element 12 directly reaches reflecting surface 17 of light flux controlling member 13, and light emitted from a side surface of light-emitting element 12 is reflected by reflection cup 14a and thereafter reaches two reflecting surfaces 17 of light flux controlling member 13. Then, the light beams having reached two reflecting surfaces 17 of light flux controlling member 13 advance in opposite directions along the horizontal direction, and are emitted to outside from two emission surfaces 19 of light flux controlling member 13.

A light-emitting element such as an LED is used for a light-emitting element used for such a light-emitting device. Many inexpensive and mass-produced LEDs are light-emitting elements (SMD-type light-emitting elements) with a light-emitting part that emits blue light and a phosphor that covers its surrounding area and converts the blue light emitted from the light-emitting part into white light, for example.

### Citation List

### Patent Literature

PTL 1 Japanese Patent Application Laid-Open No. H9-18058

### Summary of Invention

### Technical Problem

In the SMD-type light-emitting element, blue light emitted at a large angle to the light axis of the light-emitting element is easily converted to white light because it is emitted by propagating a long light path within the phosphor layer. On the other hand, blue light emitted at a small angle to the light axis of the light-emitting element is difficult to be converted to white light because the light path within the phosphor layer is short, and thus tends to be emitted as blueish light. When a light-emitting element, which is not limited to the SMD-type light-emitting element, configured to emit light with different colors depending on the output direction is applied to a light-emitting device with anisotropic light distribution characteristics, as disclosed in PTL 1, there is a problem of unevenness of color between the region where the light emitted at a small angle to the light axis of the light-emitting element reaches and the region where the light emitted at a large angle to the light axis reaches. Specifically, the light emitted at a small angle to the light axis of the light-emitting element tends to reach a specific area of the light diffusing plate in a concentrate manner, thus producing a strong blue color in that area.

In view of this, an object of the present invention is to provide a light flux controlling member that can suppress color unevenness due to a light-emitting element while maintaining desired light distribution characteristics. In addition, another object of the present invention is to provide a light-emitting device and an illumination apparatus including the light flux controlling member.

### Solution to Problem

A light flux controlling member according to the present invention is configured to control a distribution of light emitted from a light-emitting element, the light flux controlling member including: an incidence surface that is an inner surface of a recess disposed on a rear side, the incidence surface being configured to enter the light emitted from light-emitting element; two reflecting surfaces disposed on a front side, and configured to reflect a part of light entered from the incidence surface, in two opposite directions substantially perpendicular to a light axis of the light-emitting element; and two emission surfaces disposed opposite to each other with the two reflecting surfaces between the two emission surfaces, the two emission surfaces being configured to emit, to outside, light reflected by the two reflecting surfaces. The incidence surface includes a first incidence surface disposed to intersect the light axis of the light-emitting element, and two second incidence surfaces disposed to sandwich the first incidence surface between the two second incidence surfaces in a direction in which the two emission surfaces are opposite to each other, A plurality of first ridges are disposed in the first incidence surface, the plurality of first ridges having ridgelines that are approximately parallel to the direction in which the two emission surfaces are opposite to each other as viewed along the light axis of the light-emitting element. A plurality of second ridges having ridgelines that are approximately parallel to the light axis of the light-emitting element as viewed along the direction in which the two emission surfaces are opposite to each other are provided in each of the two emission surfaces, or a plurality of third ridges having ridgelines that are substantially orthogonal to the ridgelines of the plurality of first ridges as viewed along the light axis of the light-emitting element are disposed in at least a part of each of the two reflecting surfaces.

Alight-emitting device according to the present invention includes a light-emitting element; and the light flux controlling member in which the first incidence surface is disposed to intersect the light axis of the light-emitting element.

An illumination apparatus according to the present invention includes a plurality of the light-emitting devices; and a light diffusion plate configured to allow light emitted from the light-emitting device to pass through the light diffusion plate while diffusing the light.

### Advantageous Effects of Invention

According to the present invention, it is possible to provide a light flux controlling member that can suppress color unevenness due to a light-emitting element while maintaining desired light distribution characteristics.

### Brief Description of Drawings

FIG. 1 illustrates a configuration of a conventional light-emitting device;
FIGS. 2A and 2B illustrate a configuration of an illumination apparatus according to Embodiment 1;
FIG. 3 is a plan view of an illumination apparatus in the state where a light diffusion plate is removed;
FIGS. 4A to 4C illustrate a configuration of a region around a light-emitting device illustrated in FIG. 3;
FIGS. 5A to 5D illustrate a configuration of a light flux controlling member according to Embodiment 1;
FIG. 6 is a graph illustrating an exemplary cross-sectional shape of a first incidence surface;
FIG. 7 is a graph illustrating an exemplary cross-sectional shape of an emission surface;
FIG. 8 is a graph illustrating an analysis result of a chromaticity Y value on a light diffusion plate in an illumination apparatus using the light flux controlling member according to Embodiment 1, and an analysis result of a chromaticity Y value on a light diffusion plate in an illumination apparatus using a comparative light flux controlling member;
FIG. 9 is a graph illustrating an analysis result of an illuminance distribution on the light diffusion plate in the illumination apparatus using the light flux controlling member according to Embodiment 1, and an analysis result of an illuminance distribution on the light diffusion plate in the illumination apparatus using the comparative light flux controlling member;
FIGS. 10A to 10D illustrate a configuration of a light flux controlling member according to Embodiment 2;
FIG. 11A is a graph illustrating a cross-sectional shape of a reflecting surface of a light flux controlling member in a cross-section perpendicular to a ridgeline of a third ridge, FIG. 11B is a graph illustrating a result (Δh1) obtained by subtracting a set value of a cross-sectional shape of a reflecting surface of a light flux controlling member including no third ridge from a set value of a cross-sectional shape of a reflecting surface of a light flux controlling member including a third ridge in the cross-section perpendicular to the ridgeline of the third ridge;
FIG. 12 is a graph illustrating an analysis result of a chromaticity Y value on the light diffusion plate in the illumination apparatus using the light flux controlling member according to Embodiment 2, and an analysis result of a chromaticity Y value on the light diffusion plate in the illumination apparatus using the comparative light flux controlling member;
FIG. 13 is a graph illustrating an analysis result of an illuminance distribution on the light diffusion plate in the illumination apparatus using the light flux controlling member according to Embodiment 2, and an analysis result of an illuminance distribution on the light diffusion plate in the illumination apparatus using the comparative light flux controlling member;
FIGS. 14A to 14D illustrate a configuration of a light flux controlling member according to Embodiment 3;
FIG. 15 is a graph illustrating an analysis result of a chromaticity Y value on the light diffusion plate in an illumination apparatus using the light flux controlling member according to Embodiment 3, and an analysis result of a chromaticity Y value on the light diffusion plate in the illumination apparatus using the comparative light flux controlling member;
FIG. 16 is a graph illustrating an analysis result of an illuminance distribution on the light diffusion plate in the illumination apparatus using the light flux controlling member according to Embodiment 3, and an analysis result of an illuminance distribution on the light diffusion plate in the illumination apparatus using the comparative light flux controlling member; and
FIG. 17 is a partially enlarged perspective view illustrating a configuration of an illumination apparatus according to a modification.

### Description of Embodiments

An embodiment of the present invention is elaborated below with reference to the accompanying drawings.

### Embodiment 1

### Configuration of Illumination Apparatus

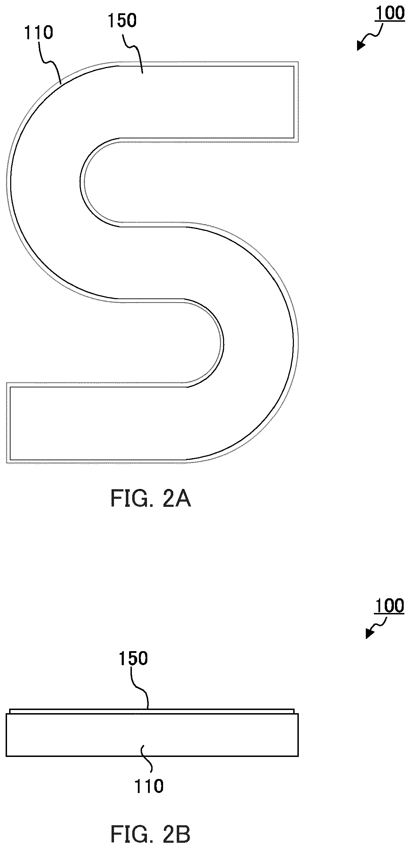

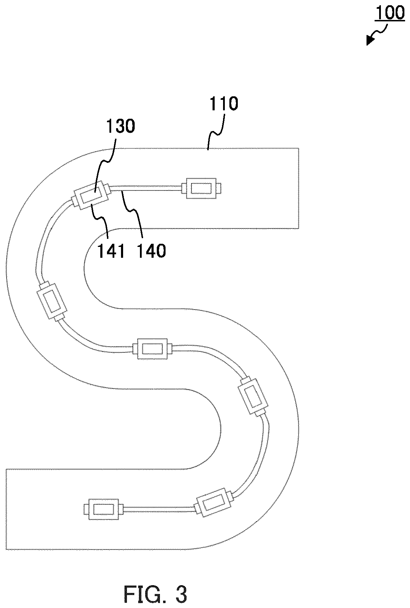

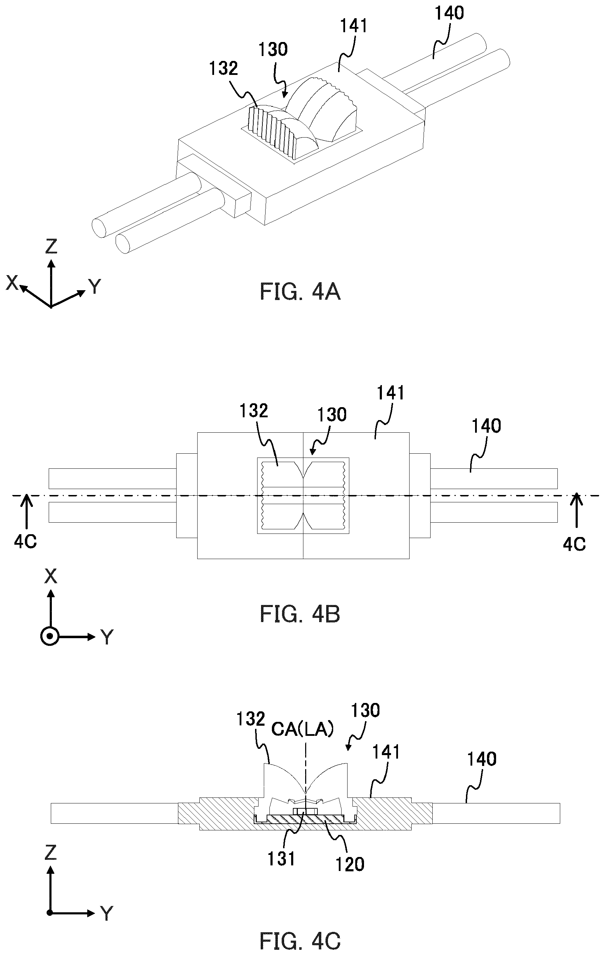

FIGS. 2A, 2B, and FIG. 3 illustrate a configuration of illumination apparatus 100 according to Embodiment 1. FIG. 2A is a plan view of illumination apparatus 100, and FIG. 2B is a front view of illumination apparatus 100. FIG. 3 is a plan view of illumination apparatus 100 according to the present embodiment from which light diffusion plate 150 is removed. FIGS. 4A to 4C illustrate a configuration of a region around light-emitting device 130 illustrated in FIG. 3. FIG. 4A is a perspective view of a region around light-emitting device 130 illustrated in FIG. 3, FIG. 4B is a plan view of FIG. 4A, and FIG. 4C is a sectional view taken along line 4C-4C of FIG. 4B. Illumination apparatus 100 illustrated in the drawings are used as a channel letter signboard, for example.

As illustrated in FIGS. 2A, 2B and 3, illumination apparatus 100 includes housing 110, a plurality of substrates 120 (not illustrated in the drawing), a plurality of light-emitting devices 130, cable 140 and light diffusion plate 150.

Housing 110 is a box-shaped member whose one surface is at least partially open and configured to house therein the plurality of substrates 120 and the plurality of light-emitting devices 130. In the present embodiment, housing 110 is composed of a bottom plate, a top plate opposite the bottom plate, and four side plates configured to connect the bottom plate and the top plate. In the top plate, an opening serving as a light emission region is formed. This opening is closed with light diffusion plate 150. The bottom plate and the top plate are parallel to each other. The height (space thickness) from the surface of the bottom plate to light diffusion plate 150 is, but not limited to, approximately 20 to 100 mm. For example, housing 110 is composed of a resin such as polymethylmethacrylate (PMMA) and polycarbonate (PC), a metal such as stainless steel and aluminum or the like.

Housing 110 may have any shape in plan view. In the present embodiment, housing 110 has an S-shape in plan view because it is used for a channel letter signboard and the like.

The plurality of substrates 120 are flat plates for disposing the plurality of light-emitting devices 130 on the bottom plate of housing 110 at a predetermined interval (see FIG. 4C). In the present embodiment, substrate 120 is disposed on the bottom plate of housing 110 with caulking material 141 described later therebetween (see FIG. 4C). The wiring line of substrate 120 is electrically connected by cable 140.

The plurality of light-emitting devices 130 are disposed on the bottom plate of housing 110 with respective substrates 120 therebetween. The number of light-emitting devices 130 disposed on the bottom plate of housing 110 is not limited. The number of light-emitting devices 130 disposed on the bottom plate of housing 110 is appropriately set based on the size of the light emission region (light-emitting surface) defined by the opening of housing 110.

Each light-emitting device 130 includes light-emitting element 131 and light flux controlling member 132. Each light-emitting device 130 is disposed such that the light axis of light emitted from light-emitting element 131 (light axis LA of light-emitting element 131 described later) is along the normal to the surface of substrate 120.

Light-emitting element 131 is a light source of illumination apparatus 100 (and light-emitting device 130). Light-emitting element 131 is disposed on substrate 120 (see FIG. 4C), and is electrically connected to a wiring line formed on or in substrate 120.

Light-emitting element 131 is a light-emitting diode (LED), for example. The emission light color of light-emitting element 131 included in light-emitting device 130 is not limited. In the present embodiment, for example, it is possible to use a light-emitting element of an SMD-type including a light emission part that emits blue light, and a phosphor that covers the periphery of the light emission part and converts blue light emitted from the light emission part into white light.

Light flux controlling member 132 controls the distribution of light emitted from light-emitting element 131, and changes the travelling direction of the light to the plane direction substrate 120, or more specifically, to two opposite directions approximately perpendicular to light axis LA of light-emitting element 131. Light flux controlling member 132 is disposed over light-emitting element 131 such that its central axis CA is aligned with light axis LA oflight-emitting element 131 (see FIG. 4C). The "light axis LA of light-emitting element 131" means a central light beam of a stereoscopic light flux emitted from light-emitting element 131. The "central axis CA of light flux controlling member 132" is a 2-fold rotationally symmetric axis, for example. In the following description, in each light-emitting device 130, the direction that passes through the light emission center of light-emitting element 131 and is parallel to light axis LA of light-emitting element 131 is referred to as a Z-axis direction, and two directions orthogonal to each other in a plane perpendicular to the Z-axis direction are referred to as an X-axis direction and a Y-axis direction. More specifically, in light flux controlling member 132 described later, the direction in which two emission surfaces 135 described later are opposite to each other is the Y-axis direction, and the direction orthogonal to the Y-axis direction in a plane perpendicular to the Z-axis direction is the X-axis direction.

The material of light flux controlling member 132 is not limited as long as light of a desired wavelength can pass therethrough. Examples of the material of light flux controlling member 132 include optically transparent resins such as polymethylmethacrylate (PMMA), polycarbonate (PC), and epoxy resin (EP), and glass.

A main feature of illumination apparatus 100 according to the present embodiment is the configuration of light flux controlling member 132. Therefore, light flux controlling member 132 is elaborated later.

Cable 140 electrically connects adjacent substrates 120. The connecting portion between substrate 120 and cable 140 is reinforced with caulking material 141 (see FIG. 4C). Examples of the material of caulking material 141 include urethane resin, silicone resin, and epoxy resin.

As described above, by electrically connecting the plurality of light-emitting devices 130 through cable 140 to form a module, the plurality of light-emitting devices 130 can be freely disposed in accordance with the shape of housing 110.

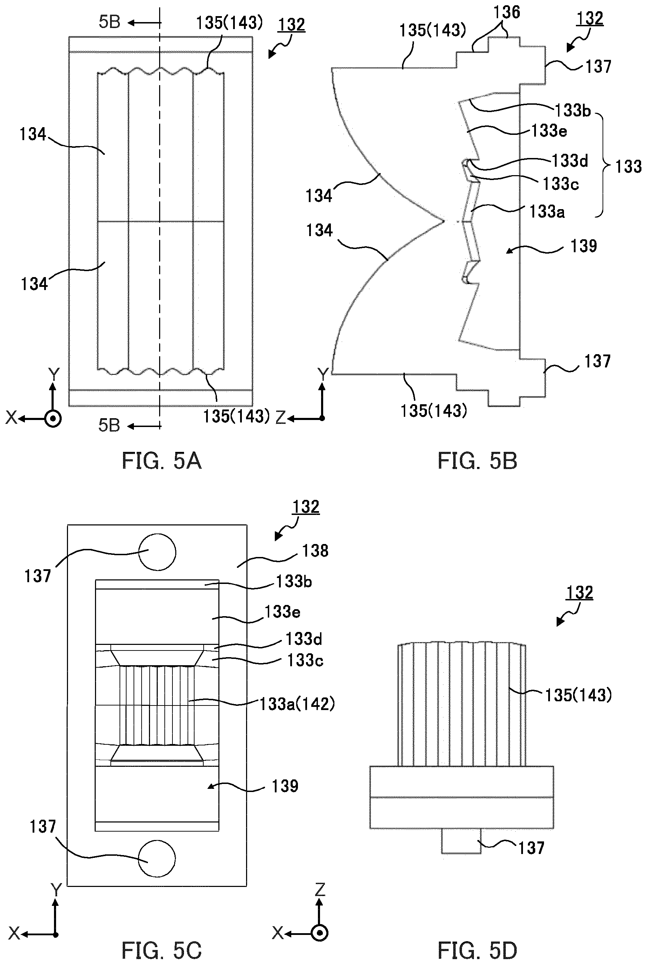

Light diffusion plate 150 is disposed to close the opening of housing 110 (see FIGS. 2A and 2B). Light diffusion plate 150 is an optically transparent and optically diffusive plate-shaped member, and allows light emitted from emission surface 135 (see FIG. 5) of light flux controlling member 132 to pass therethrough while diffusing the light. Light diffusion plate 150 can serve as a light-emitting surface of illumination apparatus 100, for example.

The material of light diffusion plate 150 is not limited as long as light emitted from emission surface 135 of light flux controlling member 132 can pass therethrough while being diffused, and examples of such a material include optically transparent resins such as polymethylmethacrylate (PMMA), polycarbonate (PC), polystyrene (PS), and styrene methyl methacrylate copolymerization resin (MS). To provide the light diffusing property, minute irregularity is formed in the surface of light diffusion plate 150, or light diffusion members such as beads are dispersed inside light diffusion plate 150.

In illumination apparatus 100 according to the present embodiment, light emitted from each light-emitting element 131 is emitted by light flux controlling member 132 while the direction is changed to two opposite directions approximately perpendicular to light axis LA of light-emitting element 131 so as to illuminate a wide range of light diffusion plate 150 (the Y-axis direction in FIGS. 4A to 4C). Light emitted from each light flux controlling member 132 is further diffused by light diffusion plate 150, and emitted to the outside. Thus, color unevenness and illuminance unevenness of illumination apparatus 100 can be suppressed.

### Configuration of Light Flux Controlling Member

FIGS. 5A to 5D illustrate a configuration of light flux controlling member 132. FIG. 5A is a plan view of light flux controlling member 132, FIG. 5B is a sectional view taken along line 5B-5B of FIG. 5A, FIG. 5C is a bottom view, and FIG. 5D is a side view.

Light flux controlling member 132 controls the distribution of light emitted from light-emitting element 131. As illustrated in FIGS. 5A to 5D, light flux controlling member 132 includes incidence surface 133, two reflecting surfaces 134, two emission surfaces 135, flange part 136 and two leg parts 137. In the following description, in light flux controlling member 132, the side on which incidence surface is formed (light-emitting element 131 side) is the rear side, and the side on which reflecting surface 134 is formed is the front side.

Incidence surface 133 allows incidence of part of light emitted from light-emitting element 131. Incidence surface 133 is an inner surface of recess 139 formed at a center portion of the rear side, i.e., bottom surface 138, of light flux controlling member 132. The inner surface shape of recess 139 is not limited, and may be an edged surface, or an edgeless curved surface of a shape such as a hemispherical shape and a semi-ellipsoid shape. In the present embodiment, the inner surface shape of recess 139 is an edged surface. More specifically, the inner surface (incidence surface 133) of recess 139 includes at least first incidence surface 133a (top surface) and two second incidence surfaces 133b (side surface), and further includes two third incidence surfaces 133c, two fourth incidence surfaces 133d, and two fifth incidence surfaces 133e between first incidence surface 133a and two second incidence surfaces 133b (see FIGS. 5B and 5C). Two second incidence surfaces 133b, two third incidence surfaces 133c, two fourth incidence surfaces 133d and two fifth incidence surfaces 133e are disposed to sandwich first incidence surface 133a in a direction parallel to the direction (Y-axis direction) in which two emission surfaces 135 are opposite to each other.

First incidence surface 133a is a surface disposed at a center portion of recess 139 in such a manner as to intersect light axis LA of light-emitting element 131. Preferably, first incidence surface 133a is formed such that light emitted from the light emission center of light-emitting element 131 at an angle of at least 0° to 10° with respect to light axis LA of light-emitting element 131 impinges on first incidence surface 133a. In addition, from the viewpoint of preventing light emitted at a small angle with respect to light axis LA of light-emitting element 131 from advancing to the boundary between two reflecting surfaces 134, first incidence surface 133a is preferably formed such that the height from the light-emitting surface of light-emitting element 131 increases in the direction toward light axis LA of light-emitting element 131. A plurality of first ridges 142 are disposed in first incidence surface 133a for the purpose of suppressing color unevenness due to light-emitting element 131 (see FIG. 5C).

The cross-sectional shape of first ridge 142 in a cross-section perpendicular to the ridgeline of first ridge 142 is not limited, and may be a wavy shape, a triangular shape, or a rectangular shape (including a trapezoidal shape). In the present embodiment, the cross-sectional shape of first ridge 142 in a cross-section perpendicular to the ridgeline of first ridge 142 is a triangular shape (see FIG. 5C).

In the present embodiment, the plurality of first ridges 142 are disposed such that as viewed along light axis LA of the light-emitting element (as viewed along the Z-axis direction), the ridgelines of the plurality of first ridges 142 are approximately parallel to the direction (Y-axis direction) in which two emission surfaces 135 are opposite to each other. It should be noted that, the extending direction of first ridge 142 may not be aligned with the Y-axis direction. Specifically, it suffices that the plurality of first ridges are formed to extend, without intersecting each other, toward two emission surfaces 135 from a virtual plane, which includes light axis LA (an XZ plane including the X axis and the Z axis) between two reflecting surfaces 134.

The "ridgeline" of first ridge 142 means a continuous line of the topmost portion of the ridge (apex), and is a line obtained by connecting the vertex of first ridge 142 in a cross-section that includes light axis LA of light-emitting element 131 and is parallel to the X-axis direction. Each first ridge 142 may include one "ridgeline", or two or more "ridgelines". For example, in the case where the cross-sectional shape of first ridge 142 is a wavy shape, the ridgeline is one line connecting the vertex of a wave. In the case where the cross-sectional shape of first ridge 142 is a trapezoidal shape, the ridgeline is two lines, namely, a line connecting the points of one of two vertexes (intersections of the upper bottom and the legs) of a trapezoid, and a line connecting the points of the other of the two vertexes.

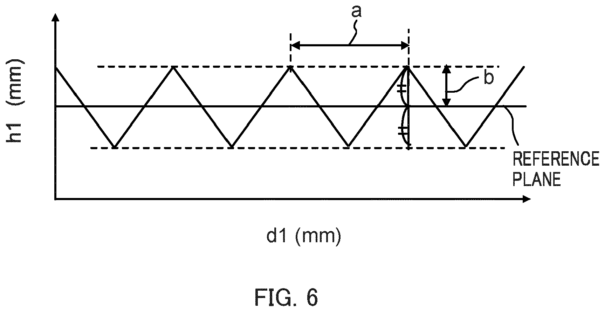

In a cross-section perpendicular to the ridgeline of first ridge 142, center-to-center distances a (the distances in the X-axis direction) of the plurality of first ridges 142 may be or may not be equal to each other. From the viewpoint of suppressing color unevenness while achieving a desired light distribution, center-to-center distances a of the plurality of first ridges 142 are preferably equal to each other. The "center-to-center distance a of the plurality of first ridges 142" is a distance between center lines of the first ridges 142 (see FIG. 6).

In a cross-section perpendicular to the ridgeline of first ridge 142, heights b (lengths in the Z axis) of the plurality of first ridges 142 may be or may not be equal to each other. From the viewpoint of suppressing color unevenness while achieving a desired light distribution, heights b of the plurality of first ridges 142 are preferably equal to each other. The "height b of first ridge 142" means a length corresponding to half of the distance between a straight line connecting the vertexes of two adjacent first ridges 142 and a straight line connecting valley bottoms of a recess formed between the two first ridges 142 and two recesses formed on both sides of thereof in a cross-section perpendicular to the ridgeline of first ridge 142 (see FIG. 6).

Heights b of the plurality of first ridges 142 may be or may not be equal to each other in the extending direction of the ridgeline of first ridge 142 (Y-axis direction). In the present embodiment, heights b of the plurality of first ridges 142 are equal to each other in the extending direction of the ridgeline (Y-axis direction).

In a cross-section perpendicular to the ridgeline of first ridge 142, the ratio of center-to-center distance a and height b of the plurality of first ridges 142 is preferably a:b=1:0.05 to 1:0.5. When the ratio a:b falls within the above-mentioned range, the travelling direction of light entered from first incidence surface 133a can be slightly changed without largely affecting the illuminance distribution on light diffusion plate 150, and therefore color unevenness can be easily suppressed while achieving a desired light distribution.

In consideration of improvement of the color unevenness, the processing accuracy of the metal mold, and the transferability in molding of the light flux controlling member, center-to-center distance a of the plurality of first ridges 142 is preferably 0.1 mm to 1 mm.

FIG. 6 is a graph illustrating an exemplary cross-sectional shape of first incidence surface 133a in a cross-section perpendicular to the ridgeline of first ridge 142. In FIG. 6, the abscissa indicates distance d1 from the center of first incidence surface 133a (the distance in the X-axis direction; mm), and the ordinate indicates height h1 of first incidence surface 133a from a reference plane (the height in the Z-axis direction; mm). The reference plane is a line connecting each middle point between the vertex of first ridge 142 and the next valley bottom in a cross-section perpendicular to the ridgeline of first ridge 142.

Two reflecting surfaces 134 are disposed on the front side of light flux controlling member 132, i.e., on the side opposite to light-emitting element 131 (light diffusion plate 150 side) with incidence surface 133 therebetween. In addition, two reflecting surfaces 134 reflect a part of light entered from incidence surface 133 in two opposite directions (the direction in which two emission surfaces 135 are opposite to each other, i.e., the Y-axis direction) substantially perpendicular to light axis LA of light-emitting element 131. In a cross-section that includes light axis LA of light-emitting element 131 and is parallel to the Y-axis direction, each of two reflecting surfaces 134 is disposed such that, with respect to light axis LA of light-emitting element 131, the height from bottom surface 138 (substrate 120) increases in the direction toward the end portion (emission surface 135) from light axis LA of light-emitting element 131. More specifically, in the cross-section, each of two reflecting surfaces 134 is formed such that the inclination of the tangent gradually decreases in the direction toward the end portion (emission surface 135) from light axis LA of light-emitting element 131.

Two emission surfaces 135 are disposed opposite to each other with two reflecting surfaces 134 therebetween. Two emission surfaces 135 emit, to the outside, light having entered from incidence surface 133 and having directly reached emission surface 135, and light reflected by two reflecting surfaces 134. For the purpose of suppressing color unevenness due to light-emitting element 131, a plurality of second ridges 143 are disposed in two emission surfaces 135 (see FIGS. 5A and 5D).

The cross-sectional shape of second ridge 143 in a cross-section perpendicular to the ridgeline of second ridge 143 is not limited, and may be a wavy shape, a triangular shape, or a rectangular shape (including a trapezoidal shape). In the present embodiment, the cross-sectional shape of second ridge 143 is a wavy shape in a cross-section perpendicular to the ridgeline of second ridge 143.

As viewed in the direction (Y-axis direction) in which two emission surfaces 135 are opposite to each other, the ridgeline of second ridge 143 is approximately parallel to light axis LA of light-emitting element 131. The "approximately parallel" means that the angle between light axis LA of light-emitting element 131 and the ridgeline of second ridge 143 as viewed along the Y-axis direction is 15° or smaller, preferably 0°. The reason for setting the angle between light axis LA and the ridgeline of second ridge 143 as small as possible is to easily remove the molded article from the metal mold without complicating the structure of the metal mold for light flux controlling member 132. In the case where a metal mold structure that slides in a direction intersecting the removal direction of the molded article can be employed, the limitation on the inclination angle with respect to light axis LA can be eliminated. In addition, when mounting light flux controlling member 132 to substrate 120, the angle between light axis LA and the ridgeline of second ridge 143 can be large.

As described above, the "ridgeline" of second ridge 143 means a continuous line of the topmost portion of the ridge, and is a line connecting vertex of second ridge 143 in a cross-section perpendicular to light axis LA of light-emitting element 131.

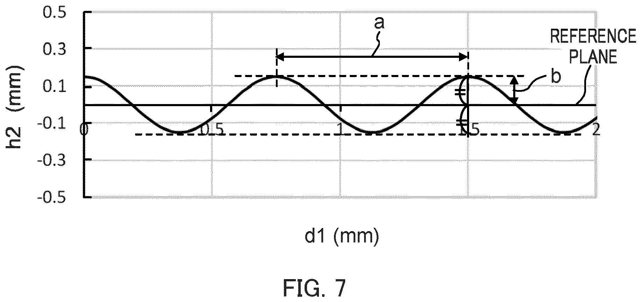

In a cross-section perpendicular to the ridgeline of second ridge 143, center-to-center distance a (the distance in the X-axis direction) of the plurality of second ridges 143 may be or may not be equal to each other. From the viewpoint of suppressing color unevenness while achieving a desired light distribution, center-to-center distance a of the plurality of second ridges 143 are preferably equal to each other. As described above, the "center-to-center distance a of the plurality of second ridges 143" is the distance between each center line of second ridges 143 in a cross-section perpendicular to the ridgeline of second ridge 143 (see FIG. 7).

In a cross-section perpendicular to the ridgeline of second ridge 143, heights b of the plurality of second ridges 143 (the length in the Y axis direction) may be or may not be equal to each other. From a view point of the ease of processing of the metal mold, heights b of the plurality of second ridges 143 are preferably equal to each other. As described above, "height b of second ridge 143" means the length corresponding to half of the distance between a straight line connecting the vertexes of adjacent two second ridges 143, and a straight line connecting the valley bottoms of a recess formed between two second ridges 143 and two recesses formed on both sides of thereof in a cross-section perpendicular to the ridgeline of second ridge 143 (see FIG. 7). In the direction parallel to light axis LA of light-emitting element 131 (the Z-axis direction), heights b of the plurality of second ridges 143 may be or may not be equal to each other.

In a cross-section perpendicular to the ridgeline of second ridge 143, the ratio of center-to-center distance a and height b of the plurality of second ridges 143 is preferably a:b=2:1 to 13:1. When the ratio a:b falls within the above-mentioned range, the travelling direction of the light emitted from two emission surfaces 135 can be slightly changed without scattering the light, and therefore color unevenness can be easily suppressed while achieving a desired light distribution. Furthermore, to not only suppress the color unevenness but also to further improve the illuminance distribution, the ratio of center-to-center distance a and height b of the plurality of second ridges 143 is more preferably a:b=5:1 to 11:1, still more preferably a:b=5:1 to 10:1.

It suffices that, in a cross-section perpendicular to the ridgeline of second ridge 143, center-to-center distance a of the plurality of second ridges 143 is set such that the ratio of center-to-center distance a and height b of the plurality of second ridges 143 falls within the above-described range, and is preferably 0.125 mm to 4.000 mm. When center-to-center distance a of the plurality of second ridges 143 falls within the above-mentioned range, the effect of suppressing the color unevenness can be easily achieved. Furthermore, in the case where the ratio of center-to-center distance a and height b of the plurality of second ridges 143 is a:b=5:1 to 10:1, center-to-center distance a of the plurality of second ridges 143 is preferably not smaller than 0.125 mm and equal to or smaller than 2.000 mm.

FIG. 7 is a graph illustrating an exemplary cross-sectional shape of emission surface 135 in a cross-section perpendicular to the ridgeline of second ridge 143. In FIG. 7, the abscissa indicates distance d1 (the distance in the X-axis direction; mm) from a center of emission surface 135 of light flux controlling member 132, and the ordinate indicates height h2 (the height in the Y-axis direction; mm) from a reference plane of emission surface 135. The reference plane is a line connecting each middle point between the vertex of second ridge 143 and the next valley bottom in a cross-section perpendicular to the ridgeline of second ridge 143.

As illustrated in FIG. 7, in a cross-section perpendicular to the ridgeline of second ridge 143, the cross-sectional shape of emission surface 135 of light flux controlling member 132 is set to satisfy Expression (1). $hy = b \times cos \left(2πdx/a\right)$ Expression (1) (where a: the center-to-center distance of the plurality of second ridges 143 (mm), b: the height of second ridge 143 (mm), d1: the distance from the center in emission surface 135 (the distance in the X-axis direction; mm), and h2: the height of emission surface 135 from the reference plane (the height in the Y-axis direction; mm))

Flange part 136 is located between each of two emission surfaces 135 and the outer periphery part of bottom surface 138 of light flux controlling member 132, and protrudes to the outside with respect to central axis CA. Flange part 136 has a substantially rectangular shape. Flange part 136 is not an essential component, but light flux controlling member 132 can be easily handled and positioned by means of flange part 136. The thickness of flange part 136 is not limited, and may be determined in consideration of the required planar dimensions of two emission surfaces 135 and the workability of flange part 136.

Two leg parts 137 are members having a substantially columnar shape protruding from bottom surface 138 and the bottom of flange part 136 toward light-emitting element 131 side at the outer periphery part of bottom surface 138 (rear surface) of light flux controlling member 132. Two leg parts 137 support light flux controlling member 132 at an appropriate position with respect to light-emitting element 131 (see FIG. 5C). Leg part 137 may be fitted to a hole formed in substrate 120 so as to position in the direction parallel to the XY plane. Note that the number of leg parts 137 is not limited.

The operation of light flux controlling member 132 according to the present embodiment is described by comparison with a comparative light flux controlling member. Note that the comparative light flux controlling member is identical to the light flux controlling member according to the present embodiment except that the plurality of first ridges 142 are not provided in first incidence surface 133a, and that the plurality of second ridges 143 are not provided in two emission surfaces 135.

In the comparative light flux controlling member (not illustrated in the drawing) and light flux controlling member 132 of the present embodiment, light emitted from light-emitting element 131 is entered from incidence surface 133. Apart of the light is reflected by two reflecting surfaces 134 so as to advance in two opposite directions perpendicular to light axis LA of light-emitting element 131, and then the light is emitted to the outside from two emission surfaces 135. The light emitted from emission surface 135 is controlled to reach a position remote from light-emitting device 130 in light diffusion plate 150 (see FIGS. 4C and 5B).

In the comparative light flux controlling member, first incidence surface 133a and two emission surfaces 135 are smooth surfaces. Accordingly, light emitted at a small angle with respect to light axis LA of light-emitting element 131 (e.g., at least at an angle of 0° to 10° with respect to light axis LA oflight-emitting element 131 from the light emission center of light-emitting element 131) is entered from the smooth surface, and as such the travelling direction of the light is not disturbed, and the light tends to reach a specific region of light diffusion plate 150 in a concentrate manner. As a result, the blue in the specific region of light-emitting element 131 is stronger than in other regions, and consequently color unevenness is easily caused.

In contrast, in light flux controlling member 132 of the present embodiment, the plurality of first ridges 142 are disposed in first incidence surface 133a (see FIG. 5C), and the plurality of second ridges 143 are disposed in two emission surfaces 135 (see FIG. 5A). With this configuration, the travelling direction of the light emitted at a small angle with respect to light axis LA of light-emitting element 131 is moderately changed by the plurality of first ridges 142 of first incidence surface 133a, and then the travelling direction of the light is further changed by the plurality of second ridges 143 of emission surface 135. As a result, the light emitted at a small angle with respect to light axis LA of light-emitting element 131 is moderately scattered in the Z-axis direction without concentrating at a specific region of light diffusion plate 150. As a result, color unevenness can be sufficiently suppressed without impairing the distribution characteristics of the light emitted from light-emitting element 131.

### Simulation 1

In Simulation 1, in illumination apparatus 100 using light flux controlling member A according to the present embodiment (light flux controlling member 132 of FIGS. 5A to 5D), the chromaticity Y value and the illuminance distribution on light diffusion plate 150 were analyzed. The chromaticity Y value and the illuminance distribution were analyzed in illumination apparatus 100 including only one light-emitting device 130.

In addition, for comparison, the chromaticity Y value and the illuminance distribution on the light diffusion plate were analyzed also in illumination apparatuses using light flux controlling member R1 (comparison 1) that is identical to light flux controlling member A except that neither first incidence surface 133a nor two emission surfaces 135 have a ridge, and light flux controlling member R2 (comparison 2) that is identical to light flux controlling member A except that no ridge is provided in two emission surfaces 135.

In light flux controlling member A (light flux controlling member 132 of FIGS. 5A to 5D), the ratio of center-to-center distance a and height b and center-to-center distance a were set as follows for the plurality of first ridges 142 of first incidence surface 133a and the plurality of second ridges 143 of two emission surfaces 135.

### Parameter of First Incidence Surface 133a

The cross-sectional shape of first ridge 142 in a cross-section perpendicular to the ridgeline of first ridge 142 was set to a triangular shape, and center-to-center distance a and height b of the plurality of first ridges 142 were set as follows.
Center-to-center distance a:height b=1:0.14
Center-to-center distance a=500 µm, height b=72 µm

### Parameter of Emission Surface 135

The shape of emission surface 135 including the plurality of second ridges 143 in a cross-section perpendicular to the ridgeline of second ridge 143 was set to satisfy Expression (1). In addition, center-to-center distance a and height b of the plurality of second ridges 143 in a cross-section perpendicular to the ridgeline of second ridge 143 were set as follows.
Center-to-center distance a:height b=7.5:1
Center-to-center distance a=750 µm, height b=100 µm

### Other Common Parameters

Outer diameter of light flux controlling member 132: 11.1 mm in length in the Y axis direction, and 9.2 mm in length in the X axis direction
Height of light-emitting element 131: 0.75 mm
Size of light-emitting element 131: ϕ2.8 mm
Distance between substrate 120 and light diffusion plate 150: 50 mm

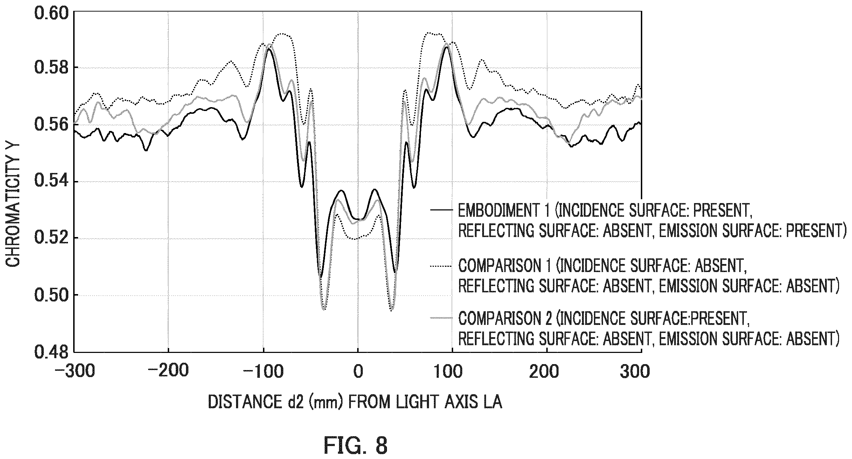

FIG. 8 is a graph illustrating an analysis result of the chromaticity Y value on the light diffusion plate of the illumination apparatus according to the present embodiment, and an analysis result of the chromaticity Y value on the light diffusion plate of the comparative illumination apparatus. In FIG. 8, the abscissa indicates distance d2 (the distance in the Y-axis direction; mm) from light axis LA of light-emitting element 131 in light diffusion plate 150, and the ordinate indicates the chromaticity Y value in light diffusion plate 150.

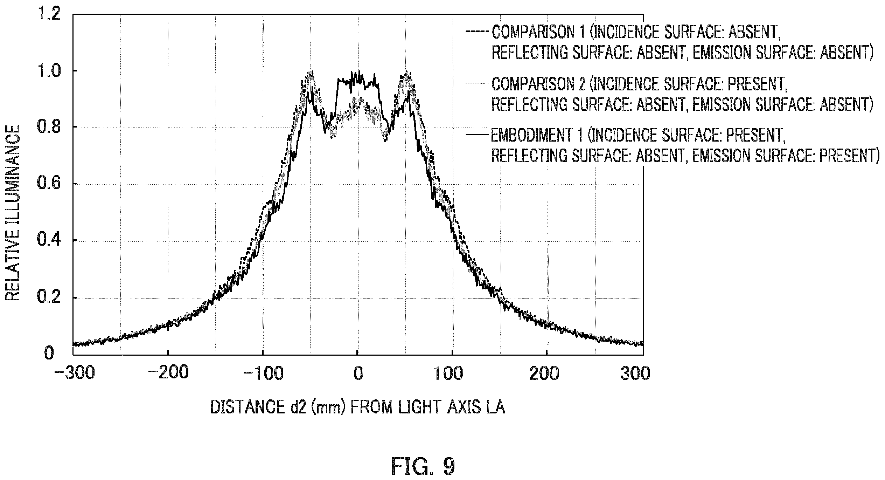

FIG. 9 is a graph illustrating an analysis result of the illuminance distribution on the light diffusion plate of the illumination apparatus according to the present embodiment, and an analysis result the illuminance distribution on the light diffusion plate of the comparative illumination apparatus. In FIG. 9, the abscissa indicates distance d2 (the distance in the Y-axis direction; mm) from light axis LA of light-emitting element 131 in light diffusion plate 150, and the ordinate indicates a relative illuminance with respect to a maximum illuminance set as 1 at each distance in light diffusion plate 150.

As illustrated in FIG. 8, in the illumination apparatuses using comparative light flux controlling members R1 and R2, the chromaticity Y value is excessively low when distance d2 from light axis LA of light-emitting element 131 is approximately 40 mm (specific region), and bluish color unevenness is caused. In contrast, in illumination apparatus 100 using light flux controlling member A according to the present embodiment, the chromaticity Y value is not excessively low when distance d2 from light axis LA of light-emitting element 131 is approximately 40 mm, and the color unevenness is reduced.

In addition, as illustrated in FIG. 9, the illuminance distribution of the illumination apparatus using light flux controlling member A according to the present embodiment is comparable to the illuminance distribution of the illumination apparatus using the comparative light flux controlling member in terms of light expansion in the Y-axis direction, and favorable light distribution characteristics are maintained.

In view of the foregoing, the illumination apparatus using the light flux controlling member according to the present embodiment can prevent the chromaticity Y value from becoming excessively low when distance d2 from light axis LA of light-emitting element 131 is approximately 40 mm and can sufficiently suppress the color unevenness while favorably maintaining the light distribution characteristics.

### Effect

As described above, in light flux controlling member 132 according to the present embodiment, the plurality of first ridges 142 and the plurality of second ridges 143 are provided in first incidence surface 133a and two emission surfaces 135, respectively. With this configuration, the emission direction of light emitted from light-emitting element 131, especially light emitted at a small angle with respect to light axis LA of light-emitting element 131 can be moderately changed and scattered without impairing the light distribution characteristics, and thus the color unevenness can be suppressed while maintaining desired light distribution characteristics.

### Embodiment 2

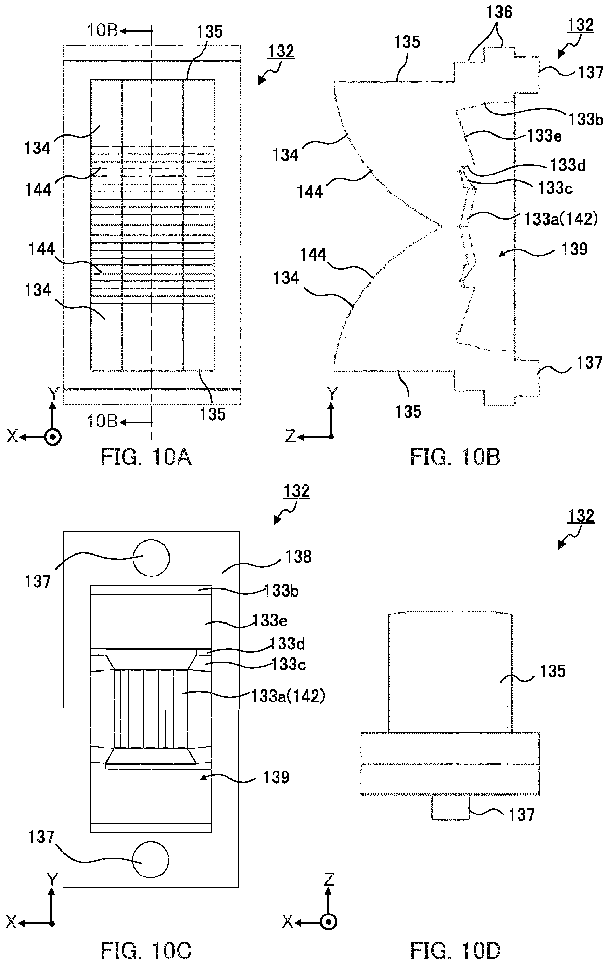

Next, with reference to FIG. 10, light flux controlling member 132 according to Embodiment 2 is described. FIGS. 10A to 10D illustrate a configuration of the light flux controlling member according to Embodiment 2. FIG. 10A is a plan view of light flux controlling member 132, FIG. 10B is a sectional view of taken along line 10B-10B of FIG. 10A, FIG. 10C is a bottom view, and FIG. 10D is a side view. Light flux controlling member 132 according to the present embodiment differs from light flux controlling member 132 according to Embodiment 1 in that two reflecting surfaces 134 include a plurality of third ridges 144 instead of the plurality of second ridges 143 in two emission surfaces 135. In view of this, the same components as those of light flux controlling member 132 according to Embodiment 1 are denoted with the same reference signs, and the description thereof will be omitted.

In light flux controlling member 132 according to the present embodiment, the plurality of third ridges 144 are additionally disposed in at least a part of two reflecting surfaces 134, preferably in a region where light entered from first incidence surface 133a reaches (see FIGS. 10A and 10B).

The region where light entered from first incidence surface 133a reaches in two reflecting surfaces 134 is, for example, a region around light axis LA of light-emitting element 131 in two reflecting surfaces 134 (see FIG. 10B). As viewed along light axis LA of light-emitting element 131 (as viewed along the Z-axis direction), third ridge 144 is formed such that the ridgeline thereof is substantially orthogonal to the ridgeline of first ridge 142. Specifically, the "substantially orthogonal" means that the angle between the ridgeline of first ridge 142 and the ridgeline of third ridge 144 is 90±5° or smaller, preferably 90°.

As described above, the "ridgeline" of third ridge 144 means a continuous line connecting the topmost portion of the ridge, and is a line obtained by connecting the vertex of third ridge 144 in a cross-section that includes light axis LA of light-emitting element 131 and is parallel to the Y-axis direction. As viewed along the Z-axis direction, the plurality of third ridges 144 may be disposed such that the ridgeline is approximately parallel to X-axis direction (see FIG. 10A), or may be disposed as a part of a circle surrounding light axis LA (not illustrated in the drawing).

The cross-sectional shape of third ridge 144 in a cross-section perpendicular to the ridgeline of third ridge 144 (a cross-section that includes light axis LA of light-emitting element 131 and is parallel to the Y-axis direction) is not limited, and may be a wavy shape, a triangular shape, or a rectangular shape (including a trapezoidal shape).

Center-to-center distance a of the plurality of third ridges 144 (the distance in the Y-axis direction) in a cross-section perpendicular to the ridgeline of third ridge 144 may be or may not be equal to each other. For example, in a cross-section perpendicular to the ridgeline of third ridge 144, center-to-center distance a of the plurality of third ridges 144 may be gradually reduced in the direction away from light axis LA of light-emitting element 131 in the Y-axis direction. As described above, center-to-center distance a of the plurality of third ridges 144 means the distance between the center lines of third ridges 144 adjacent to each other in a cross-section that includes light axis LA of light-emitting element 131 and is parallel to the Y-axis direction.

Heights b of the plurality of third ridges 144 (the length in the Z axis direction) in a cross-section perpendicular to the ridgeline of third ridge 144 may be or may not be equal to each other. For example, in a cross-section perpendicular to the ridgeline of third ridge 144 (a cross-section that includes light axis LA of light-emitting element 131 and is parallel to the Y-axis direction), height b of third ridge 144 may be gradually reduced in the direction away from light axis LA oflight-emitting element 131 in the Y-axis direction. The "height b of third ridge 144" means the length corresponding to half of the distance between a straight line connecting the vertexes of two third ridges 144 adjacent to each other, and a straight line connecting the valley bottoms of a recess formed between two third ridges 144 and two recesses formed on both sides thereof in a cross-section perpendicular to the ridgeline of third ridge 143.

As described above, in light flux controlling member 132 according to the present embodiment, the plurality of first ridges 142 are disposed in first incidence surface 133a, and further, the plurality of third ridges 144 are additionally disposed in two reflecting surfaces 134. With this configuration, the travelling direction of the light whose travelling direction is changed by first ridge 142 can be further changed by third ridge 144, and thus color unevenness can be more significantly suppressed.

### Simulation 2

In Simulation 2, in illumination apparatus 100 using light flux controlling member B according to the present embodiment (light flux controlling member 132 of FIGS. 10A to 10D), the chromaticity Y value and the illuminance distribution on light diffusion plate 150 were analyzed. The chromaticity Y value and the illuminance distribution were analyzed in illumination apparatus 100 including only one light-emitting device 130.

In addition, for comparison, the chromaticity Y value and the illuminance distribution on the light diffusion plate were analyzed also in illumination apparatuses using light flux controlling member R1 (comparison 1) that is identical to light flux controlling member B except that neither first incidence surface 133a nor two reflecting surfaces 134 have a ridge, and light flux controlling member R3 (comparison 3) that is identical to light flux controlling member B except that no ridge is provided in two reflecting surfaces 134.

In light flux controlling member B (light flux controlling member 132 of FIGS. 10A to 10D), the ratio of center-to-center distance a and height b and center-to-center distance a were set as follows for the plurality of first ridges 142 of first incidence surface 133a and the plurality of third ridges 144 of two reflecting surfaces 134. Other common parameters were set as in Simulation 1.

### Parameter of First Incidence Surface 133a

In a cross-section perpendicular to the ridgeline of first ridge 142, the cross-sectional shape of first ridge 142 was set to a triangular shape, and center-to-center distance a and height b of the plurality of first ridges 142 were set as follows.
Center-to-center distance a:height b=1:0.14
Center-to-center distance a=500 µm, height b=72 µm

### Parameter of Reflecting Surface 134

First, the cross-sectional shape of two reflecting surfaces 134 of light flux controlling member B in a cross-section perpendicular to the ridgeline of third ridge 144 (a cross-section that includes light axis LA of light-emitting element 131 and is parallel to the Y-axis direction) was set.

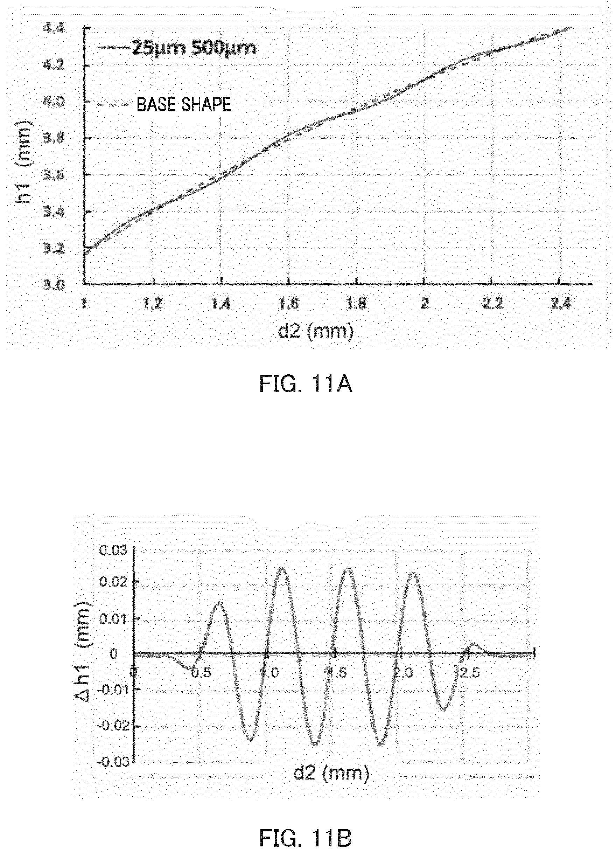

FIG. 11A is a graph illustrating a part of a cross-sectional shape of reflecting surface 134 of light flux controlling member B in a cross-section perpendicular to the ridgeline of third ridge 144. FIG. 11B is a graph illustrating a result (Δh1; mm) obtained by subtracting an analysis result of the cross-sectional shape of reflecting surface 134 of a light flux controlling member that is identical to light flux controlling member B except that no third ridge 144 is provided, from an analysis result of the cross-sectional shape of reflecting surface 134 of light flux controlling member B of FIGS. 10A to 10D including third ridge 144 in a cross-section perpendicular to the ridgeline of third ridge 144.

In FIGS. 11A and 11B, the abscissa indicates distance d2 from light axis LA of light-emitting element 131 (the distance in the Y-axis direction; mm). In FIG. 11A, the ordinate indicates height h1 of reflecting surface 134 from bottom surface 138 (the height in the Z-axis direction; mm) with respect to intersection of light axis LA of light-emitting element 131. In FIG. 11B, the ordinate indicates value Δh1 (the height in the Z-axis direction; mm) obtained by subtracting the cross-sectional shape of reflecting surface 134 of a light flux controlling member including no third ridge 144 from the cross-sectional shape of reflecting surface 134 of light flux controlling member B including third ridge 144.
a: Center-to-center distance of third ridge 144 (mm)
b: Height of third ridge 144 (the length in the Z axis direction; mm)
Center-to-center distance a :height b (of third ridge 144) =20:1
Center-to-center distance a of third ridge 144 =500 µm, height b of third ridge 144 =25 µm

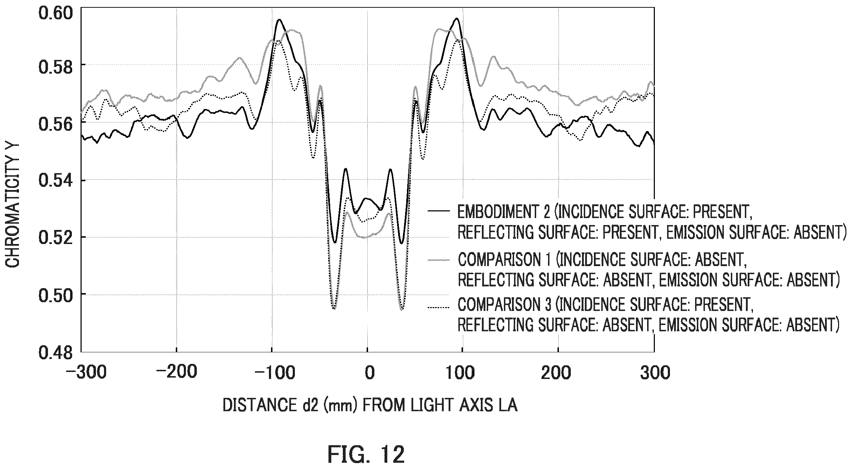

FIG. 12 is a graph illustrating an analysis result of the chromaticity Y value on the light diffusion plate of the illumination apparatus according to the present embodiment, and an analysis result of the chromaticity Y value on the light diffusion plate of the comparative illumination apparatus. In FIG. 12, the abscissa indicates distance d2 (the distance in the Y-axis direction; mm) from light axis LA of light-emitting element 131 in light diffusion plate 150, and the ordinate indicates the chromaticity Y value in light diffusion plate 150.

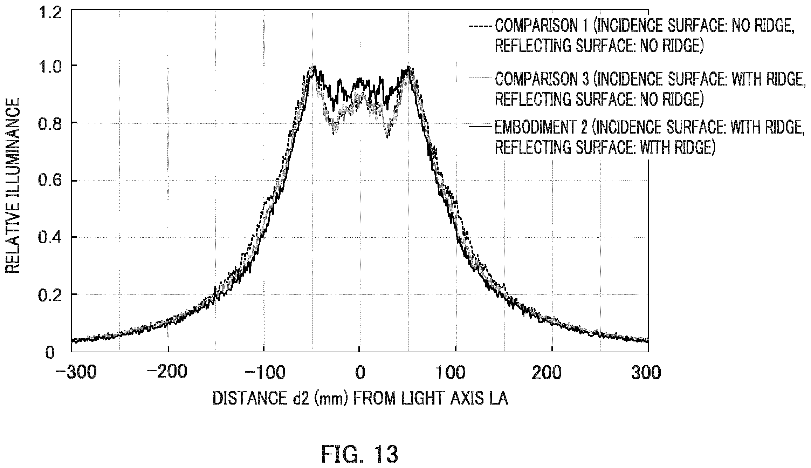

FIG. 13 is a graph illustrating an analysis result of the illuminance distribution on the light diffusion plate of the illumination apparatus according to the present embodiment, and an analysis result the illuminance distribution on the light diffusion plate of the comparative illumination apparatus. In FIG. 13, the abscissa indicates distance d2 (the distance in the Y-axis direction; mm) from light axis LA of light-emitting element 131 in light diffusion plate 150, and the ordinate indicates a relative illuminance with respect to a maximum illuminance set as 1 at each distance in light diffusion plate 150.

As illustrated in FIG. 12, in illumination apparatuses using comparative light flux controlling members R1 and R3, the chromaticity Y value is excessively low when distance d2 from light axis LA of light-emitting element 131 is approximately 40 mm, and bluish color unevenness is caused. In contrast, in illumination apparatus 100 using light flux controlling member B according to the present embodiment, the chromaticity Y value is not excessively low when distance d2 from light axis LA of light-emitting element 131 is approximately 40 mm, and the color unevenness is reduced.

In addition, as illustrated in FIG. 13, the illuminance distribution of the illumination apparatus using light flux controlling member B according to the present embodiment is comparable to the illuminance distribution of the illumination apparatus using the comparative light flux controlling member in terms of light expansion of the Y-axis direction, and favorable light distribution characteristics are maintained.

In view of the foregoing, the illumination apparatus using the light flux controlling member according to the present embodiment can prevent the chromaticity Y value from becoming locally excessively lowered when distance d2 from light axis LA of light-emitting element 131 is approximately 40 mm, and can sufficiently suppress the color unevenness while favorably maintaining the light distribution characteristics.

### Effect

As described above, in light flux controlling member 132 according to the present embodiment, the plurality of first ridges 142 are disposed in first incidence surface 133a, and further, the plurality of third ridges 144 are additionally disposed in two reflecting surfaces 134. With this configuration, the emission direction of light emitted from light-emitting element 131, especially light emitted at a small angle with respect to light axis LA of light-emitting element 131 can be moderately changed and scattered without impairing the light distribution characteristics, and thus the color unevenness can be suppressed while maintaining desired light distribution characteristics.

### Embodiment 3

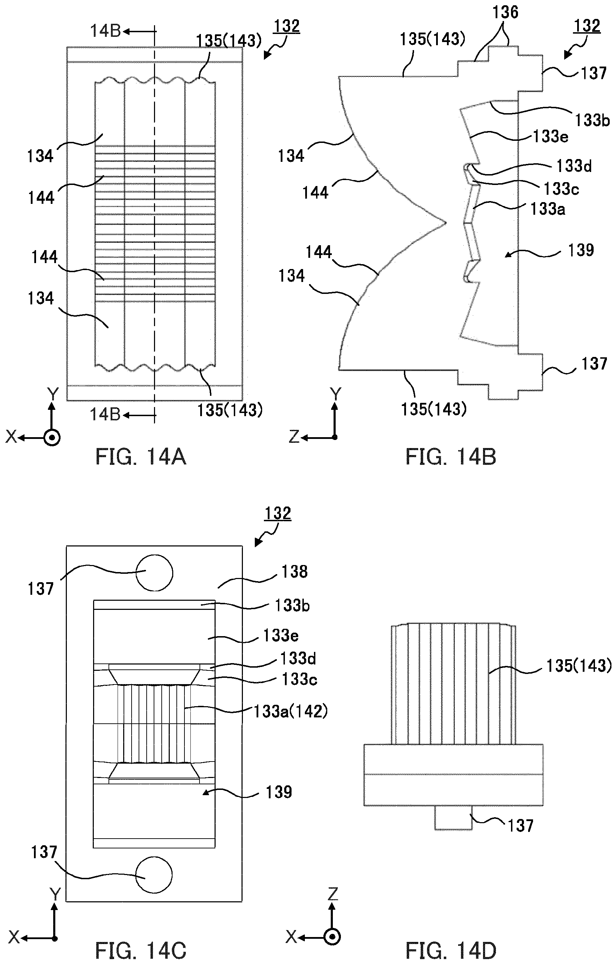

Next, with reference to FIG. 14, light flux controlling member 132 according to Embodiment 3 is described. FIGS. 14A to 14D illustrate a configuration of the light flux controlling member according to Embodiment 3. FIG. 14A is a plan view of light flux controlling member 132, FIG. 14B is a sectional view taken along line 14B-14B of FIG. 14A, FIG. 14C is a bottom view, and FIG. 14D is a side view. Light flux controlling member 132 according to the present embodiment differs from light flux controlling member 132 according to Embodiment 1 in that two reflecting surfaces 134 further include the plurality of third ridges 144. In view of this, the same components as those of light flux controlling member 132 according to Embodiment 1 are denoted with the same reference signs, and the description thereof will be omitted.

In light flux controlling member 132 according to the present embodiment, the plurality of third ridges 144 are additionally disposed in at least a part of two reflecting surfaces 134, preferably in a region where light entered from first incidence surface 133a reaches (see FIGS. 14A and 14B). The plurality of third ridges 144 are identical to those of Embodiment 2. That is, as viewed along light axis LA of light-emitting element 131 (as viewed along the Z-axis direction), third ridge 144 is formed such that the ridgeline thereof is substantially orthogonal to the ridgeline of first ridge 142.

### Simulation 3

In Simulation 3, in illumination apparatus 100 using light flux controlling member C according to the present embodiment (light flux controlling member 132 of FIGS. 14A to 14D), the chromaticity Y value and the illuminance distribution on light diffusion plate 150 were analyzed. The chromaticity Y value and the illuminance distribution were analyzed in illumination apparatus 100 including only one light-emitting device 130.

In addition, for comparison, the chromaticity Y value and the illuminance distribution on the light diffusion plate were analyzed also in an illumination apparatus using light flux controlling member R1 (comparison 1) that is identical to light flux controlling member C except that neither first incidence surface 133a, two reflecting surfaces 134 nor two emission surfaces 135 have a ridge, and light flux controlling member A (Embodiment 1) that is identical to light flux controlling member C except that only two reflecting surfaces 134 are not provided with a ridge, and an illumination apparatus using light flux controlling member B (Embodiment 2) that is identical to light flux controlling member C except that only two emission surfaces 135 are not provided with a ridge.

In light flux controlling member C (light flux controlling member 132 in FIGS. 14A to 14D), the ratio of center-to-center distance a and height b and center-to-center distance a were set for the plurality of first ridges 142 of first incidence surface 133a and the plurality of second ridges 143 of two emission surfaces 135 as in Simulation 1. The ratio of center-to-center distance a and height b and center-to-center distance of the plurality of third ridges 144 of two reflecting surfaces 134 were set as in Simulation 2. Other common parameters were set as in Simulation 1.

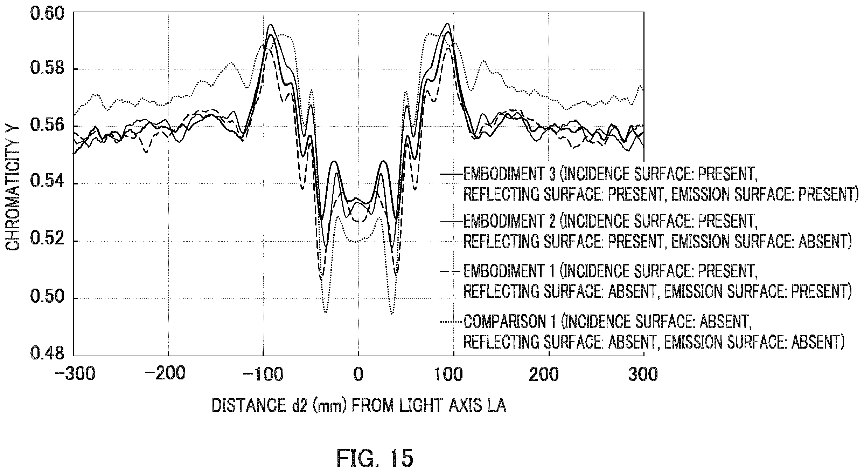

FIG. 15 is a graph illustrating an analysis result of the chromaticity Y value on the light diffusion plate of the illumination apparatus according to the present embodiment, and an analysis result of the chromaticity Y value on the light diffusion plate of the comparative illumination apparatus. In FIG. 15, the abscissa indicates distance d2 (the distance in the Y-axis direction; mm) from light axis LA of light-emitting element 131 in light diffusion plate 150, and the ordinate indicates the chromaticity Y value in light diffusion plate 150.

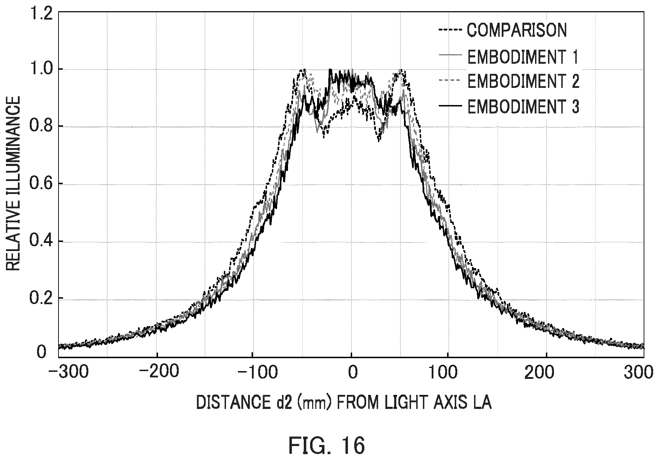

FIG. 16 is a graph illustrating an analysis result of the illuminance distribution on the light diffusion plate of the illumination apparatus according to the present embodiment, and an analysis result the illuminance distribution on the light diffusion plate of the comparative illumination apparatus. In FIG. 16, the abscissa indicates distance d2 (the distance in the Y-axis direction; mm) from light axis LA of light-emitting element 131 in light diffusion plate 150, and the ordinate indicates a relative illuminance with respect to a maximum illuminance set as 1 at each distance in light diffusion plate 150.

As illustrated in FIG. 15, in the illumination apparatus using comparative light flux controlling member R1, the chromaticity Y value is excessively low when distance d2 from light axis LA of light-emitting element 131 is approximately 40 mm, and bluish color unevenness is caused. In contrast, in illumination apparatus 100 using light flux controlling members A to C, especially light flux controlling member C according to the present embodiment, the chromaticity Y value is not excessively low when distance d2 from light axis LA of light-emitting element 131 is approximately 40 mm, and the color unevenness is significantly reduced.

In addition, as illustrated in FIG. 16, the illuminance distribution of the illumination apparatus using light flux controlling member C according to the present embodiment is comparable to the illuminance distributions of the illumination apparatus using comparative light flux controlling member R1, and the illumination apparatuses using light flux controlling member A of Embodiment 1 and light flux controlling member B of Embodiment 2 in terms of light expansion in the Y-axis direction, and favorable light distribution characteristics are maintained.

In view of the foregoing, the illumination apparatus using the light flux controlling member according to the present embodiment can further prevent the chromaticity Y value from becoming excessively low when distance d2 from light axis LA of light-emitting element 131 is approximately 40 mm, and can further suppress the color unevenness while favorably maintaining the light distribution characteristics.

### Effect

As described above, in light flux controlling member 132 according to the present embodiment, the plurality of first ridges 142 are disposed in first incidence surface 133a, and the plurality of second ridges 143 are disposed in two emission surfaces 135, and further, the plurality of third ridges 144 are additionally disposed in two reflecting surfaces 134. With this configuration, the emission direction of light emitted from light-emitting element 131, especially light emitted at a small angle with respect to light axis LA of light-emitting element 131 can be further changed and scattered without impairing the light distribution characteristics, and thus color unevenness can be further suppressed while maintaining desired light distribution characteristics.

### Modification

While the plurality of first ridges 142 are provided only in a center portion of first incidence surface 133a in light flux controlling member 132 in Embodiments 1 to 3, the present invention is not limited to this, and the plurality of first ridges 142 may be provided in the entirety of first incidence surface 133a. Likewise, while the plurality of second ridges 143 are provided in the entire surface of emission surface 135 in Embodiments 1 and 3, the present invention is not limited to this, and the plurality of second ridges 143 may be provided only in a part of emission surface 135.

In addition, while the plurality of first ridges 142 are provided in first incidence surface 133a that is a flat surface in light flux controlling member 132 in Embodiments 1 to 3, the present invention is not limited to this, and the plurality of first ridges 142 may be provided in first incidence surface 133a that is a curved surface (e.g., a recessed surface).

In addition, while the inner surface shape of recess 139 is an edged surface in light flux controlling member 132 in Embodiments 1 to 3, the present invention is not limited to this, and the inner surface shape of recess 139 may be an edgeless curved surface such as a hemispherical shape and a semi-ellipsoidal shape. In such a case, first incidence surface 133a, third incidence surface 133c, fourth incidence surface 133d, fifth incidence surface 133e and second incidence surface 133b may be continuously (successively) formed.

In addition, while the inner surface shape of recess 139 further includes two third incidence surfaces 133c, two fourth incidence surfaces 133d, and two fifth incidence surfaces 133e in addition to first incidence surface 133a (top surface) and two second incidence surfaces 133b (side surface) in light flux controlling member 132 in Embodiments 1 to 3, the present invention is not limited to this, and at least one of two third incidence surfaces 133c, two fourth incidence surfaces 133d and two fifth incidence surfaces 133e may be omitted.

In addition, while two emission surfaces 135 are approximately parallel (not tilted) to light axis LA of light-emitting element 131 in a cross-section that includes light axis LA of light-emitting element 131 and is parallel to the Y-axis direction in light flux controlling member 132 in Embodiments 1 to 3, the present invention is not limited to this, and two emission surfaces 135 may be slightly tilted with respect to light axis LA of light-emitting element 131. For example, emission surface 135 may be tilted toward light axis LA of light-emitting element 131 in the direction away from light-emitting element 131 along the Z axis in a cross-section that includes light axis LA of light-emitting element 131 and is parallel to the Y-axis direction. The inclination angle of emission surface 135 with respect to light axis LA of light-emitting element 131 in a cross-section that includes light axis LA of light-emitting element 131 and is parallel to the Y-axis direction may be 10° or smaller, for example.

In addition, while the plurality of light-emitting devices 130 are disposed in a line in illumination apparatus 100 in Embodiments 1 to 3, the present invention is not limited to this, and the plurality of light-emitting devices 130 may be disposed in two or more lines.

In addition, while a plurality of substrates 120 are disposed for respective light-emitting devices 130 and substrates 120 are electrically connected through cable 140 in illumination apparatus 100 in Embodiments 1 to 3, the present invention is not limited to this, and the plurality of light-emitting devices 130 may be disposed on one substrate 120. In such a case, cable 140 and caulking material 141 are unnecessary.

In addition, while housing 100 is a box-shaped member including a bottom plate, a four side plates, and a top plate (provided with an opening in at least a part of the plate) in illumination apparatus 100 in Embodiments 1 to 3, the present invention is not limited to this, and the side plate and the top plate may be omitted as long as at least bottom plate is provided.

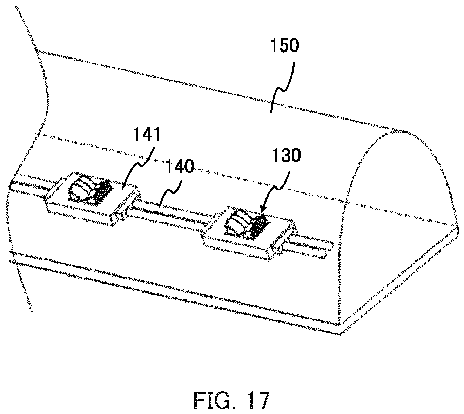

FIG. 17 is a partially enlarged perspective view illustrating a configuration of an illumination apparatus according to a modification. As illustrated in FIG. 17, the top plate and the side plate of housing 110 may be omitted such that the bottom plate of housing 110 is covered with only light diffusion plate 150.

In addition, while illumination apparatus 100 is a channel letter signboard in Embodiments 1 to 3, the present invention is not limited to this, and illumination apparatus 100 may be a line illumination.

This application is entitled to and claims the benefit of Japanese Patent Application No. 2018-027155 filed on February 19, 2018, the disclosure each of which including the specification, drawings and abstract is incorporated herein by reference in its entirety.

### Industrial Applicability

The illumination apparatus including the light flux controlling member according to the embodiment of the present invention is applicable to a signboard (in particular, a channel letter signboard), a line illumination, a generally-used illumination apparatus and the like, for example.

### Reference Signs List

- 100: Illumination apparatus
- 110: Housing
- 120: Substrate
- 130: Light-emitting device
- 131: Light-emitting element
- 132: Light flux controlling member
- 133: Incidence surface
- 133a: First incidence surface
- 133b: Second incidence surface
- 133c: Third incidence surface
- 133d: Fourth incidence surface
- 133e: Fifth incidence surface
- 134: Reflecting surface
- 135: Emission surface
- 136: Flange part
- 137: Leg part
- 138: Bottom surface
- 139: Recess
- 140: Cable
- 141: Caulking material
- 142: First ridge
- 143: Second ridge
- 144: Third ridge
- 150: Light diffusion plate
- CA: Central axis
- LA: Light axis

## Claims

1. A light flux controlling member configured to control a distribution of light emitted from a light-emitting element, the light flux controlling member comprising:
an incidence surface that is an inner surface of a recess disposed on a rear side, the incidence surface being configured to enter the light emitted from light-emitting element;
two reflecting surfaces disposed on a front side, and configured to reflect a part of light entered from the incidence surface, in two opposite directions substantially perpendicular to a light axis of the light-emitting element; and
two emission surfaces disposed opposite to each other with the two reflecting surfaces between the two emission surfaces, the two emission surfaces being configured to emit, to outside, light reflected by the two reflecting surfaces,
wherein the incidence surface includes a first incidence surface disposed to intersect the light axis of the light-emitting element, and two second incidence surfaces disposed to sandwich the first incidence surface between the two second incidence surfaces in a direction in which the two emission surfaces are opposite to each other,
wherein a plurality of first ridges are disposed in the first incidence surface, the plurality of first ridges having ridgelines that are approximately parallel to the direction in which the two emission surfaces are opposite to each other as viewed along the light axis of the light-emitting element, and
wherein a plurality of second ridges having ridgelines that are approximately parallel to the light axis of the light-emitting element as viewed along the direction in which the two emission surfaces are opposite to each other are provided in each of the two emission surfaces, or a plurality of third ridges having ridgelines that are substantially orthogonal to the ridgelines of the plurality of first ridges as viewed along the light axis of the light-emitting element are disposed in at least a part of each of the two reflecting surfaces.

2. The light flux controlling member according to claim 1, wherein the plurality of second ridges are disposed in each of the two emission surfaces.

3. The light flux controlling member according to claim 2, wherein the plurality of third ridges are disposed in at least a part of each of the two reflecting surfaces.

4. The light flux controlling member according to claim 1, wherein the plurality of third ridges are disposed in at least a part of each of the two reflecting surfaces.

5. The light flux controlling member according to any one of claims 1 to 4, wherein in a cross-section perpendicular to the ridgelines of the plurality of first ridges, a ratio of a center-to-center distance a and a height b of the plurality of first ridges is a:b=1 :0.05 to 1:0.5.

6. The light flux controlling member according to any one of claims 1 to 5, wherein in a cross section including the light axis of the light-emitting element, a height of the first incidence surface from a light-emitting surface of the light-emitting element increases in a direction toward the light axis of the light-emitting element.

7. A light-emitting device comprising:
a light-emitting element; and
the light flux controlling member according to any one of claims 1 to 6, wherein the first incidence surface is disposed to intersect the light axis of the light-emitting element.

8. The light-emitting device according to claim 7, wherein light emitted from a light emission center of the light-emitting element at an angle of at least 0° to 10° with respect to the light axis of the light-emitting element impinges on the first incidence surface.

9. An illumination apparatus comprising:
a plurality of the light-emitting devices according to claim 7 or 8; and
a light diffusion plate configured to allow light emitted from the light-emitting device to pass through the light diffusion plate while diffusing the light.
